# EUROPEAN PATENT SPECIFICATION

(11) **EP 4 609 138 B1**
(45) Date of publication and mention of the grant of the patent: **19.08.2026**
(21) Application number: 23800944.3
(22) Date of filing: 23.10.2023
(51) Int. Cl.: F28D 9/00, F28D 21/00

(54) **HEAT EXCHANGER FOR LIQUID COOLANT**
WÄRMETAUSCHER FÜR FLÜSSIGES KÜHLMITTEL
ÉCHANGEUR DE CHALEUR POUR LIQUIDE DE REFROIDISSEMENT

(30) Priority: 24.10.2022 GB 202215712
(43) Date of publication of application: 03.09.2025
(73) Proprietor: Iceotope Group Limited, Rotherham, South Yorkshire S60 5WG (GB)
(72) Inventor: AMOS, David, Rotherham South Yorkshire S60 5WG (GB); LONGHURST, Nathan, Rotherham South Yorkshire S60 5WG (GB); KADHIM, Mustafa, Rotherham South Yorkshire S60 5WG (GB)
(74) Representative: IK-IP LTD
(86) International application number: PCT/GB2023/052774
(87) International publication number: WO 2024/089409

(56) References cited:
- WO-A1-2020/234600
- WO-A1-2021/099768
- WO-A1-2022/106582
- US-A1- 2022 110 225

## Description

### Technical Field of the Disclosure

The disclosure concerns a heat exchanger, a module for cooling electronic components comprising such a heat exchanger and a method for configuring a heat exchanger.

### Background to the Disclosure

Within computers, servers, or other devices used for data processing (referred to as IT, or Information Technology), are a number of electronic devices called Integrated Circuits (IC). The electronic devices within the integrated circuits may include central processing units (CPUs), Application Specific Integrated Circuits (ASICs), Graphical Processing Units (GPUs), Random Access Memory (RAM), etc. Each of these devices produce heat when in use. In order to maintain the devices at an optimum temperature for correct operation, this heat should be transferred away from the devices. As the processing power of IT increases and so the number of electronic devices within a computer, server or other IT grows, the challenge of removing sufficient heat created by the electronic devices increases.

The electronic devices, normally mounted on a printed circuit board (PCB), are usually housed or enclosed within a case, housing or chassis, to form an electronic module. A computer server system often comprises a number of electronic modules, mounted in a rack and connected together in order to provide the required IT facilities. A method for removal of heat from each case or chassis is required, in order to maintain the electronic devices within the chassis at an appropriate temperature.

It is common to cool an electronic module by passing air over or through each case or chassis. The flow of air may be sufficient to remove some heat from inside the enclosure, to the surrounding environment. This method of cooling has, until recently, been used almost exclusively for mass-manufactured IT and server equipment. However, it has been found that, as technology size decreases for the same computing performance, the heat produced by electronic devices is increasing even as the footprint decreases. As such, the peak performance of IT systems has been throttled or constrained by the limitations of cooling an electronic module with air cooled systems.

Accordingly, more complex systems and methods for cooling electronic modules have been proposed. In some cases, liquid cooling has been used, in which a liquid coolant is flowed over, or flowed in proximity to a heat sink coupled to, the electronic devices. The heat can then be transferred away from the electronic devices, to an area or element at which the heat can be removed from the liquid coolant. Liquid cooling can in some cases provide more efficient transfer of heat away from the electronic devices or components, and so a greater cooling power than air cooled systems. However, state of the art liquid cooling systems often use customised systems, which can be complex and expensive to install. Furthermore, improvements to the cooling performance will always be desired.

International patent application publication WO-2022/106582 (commonly assigned with the present disclosure) discloses a heat exchanger according to the preamble of claim 1 and discusses an approach in which liquid immersion cooling, for instance based on a dielectric coolant, may be combined with cold plates, fed by a second liquid coolant, for example a water-based coolant. Heat may be transferred from the dielectric coolant to the second liquid coolant in a heat exchanger, which is advantageously in the same chassis as the immersion coolant and electronics being cooled. The second liquid coolant is typically provided from external the chassis, for instance from a building or facility water supply.

To assist with this approach, there is also disclosed a heat exchanger, for example a plate heat exchanger, comprising six ports. The ports are a combination of inlet and outlet ports. The heat exchanger may comprise a first chamber, through which a first liquid coolant flows, and a second chamber through which a second liquid coolant flows, with the first and second chambers separated by a thermally conductive interface. Heat may pass through the thermally conductive interface from the first liquid coolant to the second liquid coolant, or to the first liquid coolant from the second liquid coolant, dependant on the temperature gradient across the thermally conductive interface. The six ports may be arranged across each of the first and the second chamber, wherein each of the first and second chamber have at least one inlet port and at least one outlet port.

One beneficial implementation of this heat exchanger provides the second chamber comprises with at least two pathways for second liquid coolant to flow therethrough. A pathway may be considered as a route or passage through the chamber having a certain starting point (input) and ending point (output). Different pathways have different combinations of starting points (inputs) and ending points (outputs), although some of the individual inputs and outputs may be shared or common to different pathways. Each chamber of the heat exchanger is considered to be a region that is fluidly connected within the chamber, but that is fluidly separate to any other chamber. Different pathways through a chamber are fluidly connected, although specific pairs of pathways through the same chamber may not necessarily join or cross at any point (but instead be joined via another pathway in the same chamber).

For instance, the second chamber may comprise two pathways for second liquid coolant therethrough: a first pathway from a first inlet port to a first outlet port; and a second pathway from the first inlet port to a second outlet port. A third pathway from the second inlet port to the second outlet port may also be provided. In other words, the second liquid coolant may flow into the heat exchanger through the thermally conductive interface and then out of the heat exchanger or it may flow into and out of the heat exchanger without flowing through the thermally conductive interface.

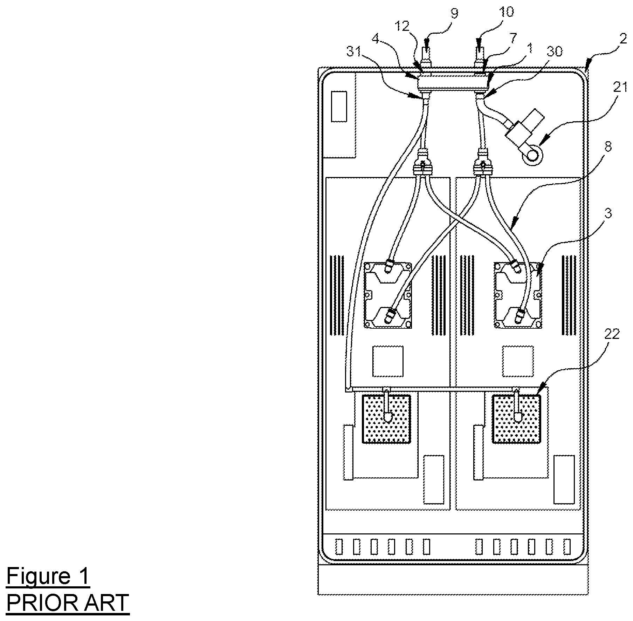

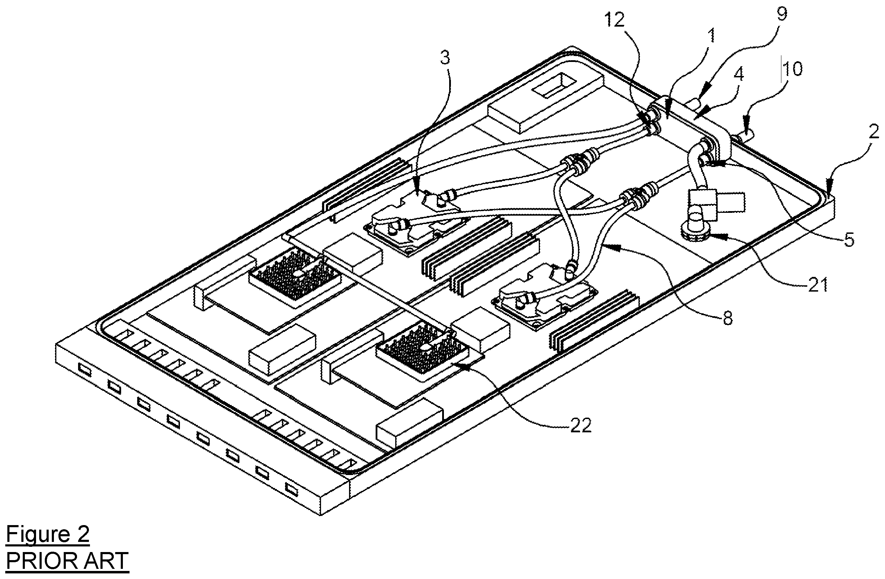

In this respect, reference is made to Figure 1, showing a top-down view of an exemplary module (server) comprising a six-port heat exchanger, similar to Figure 20A of WO-2022/106582. Referring to Figure 2, there is also shown an isometric view of the module of Figure 1. The module comprises: a chassis 2; a heat exchanger 1; a cold plate 3; a pump 9; pipework 8; and a dielectric (primary) coolant heat sink 21. Specifically, two cold plates 3 and two heat sinks 21 are shown in this example. The heat exchanger 1 comprises three pairs of ports: a dielectric coolant input port 30; a dielectric coolant output port 31; a first secondary coolant input port 7; a first secondary coolant output port 9; a second secondary coolant output port 5; and a second secondary coolant input (return flow) port 12. The first secondary coolant input port 7 is also shown with an external connector 10. The heat exchanger 1 is a plate heat exchanger, which has a thermal transfer interface, in the form of plates 4.

In an advantageous mode of operation, the dielectric coolant is received at the pump 9 and flows into the heat exchanger 1 via the dielectric coolant input port 30. It is cooled by the plates 4 and flows out of the dielectric coolant output port 31 to the dielectric coolant heat sink 21. The dielectric coolant heat sink 21 operates as described in International patent application publication WO-2019/048864. Dielectric coolant that overflows from the dielectric coolant heat sink 21 cools other heat generating components and collects in the chassis, before being pumped back to the heat exchanger 1. This creates a dielectric coolant loop.

The secondary coolant is received at the heat exchanger 1 via the first secondary coolant input port 7. Some of this secondary coolant passes through the plates 4 (thereby cooling the dielectric coolant) and then flows out of the heat exchanger 1 via the first secondary coolant output port 9. Some of the secondary coolant flows through the heat exchanger to second secondary coolant output port 5, flowing from there to the cold plate 3 via the pipework 8. Return flow from the cold plate 3 enters the heat exchanger 1 through the second secondary coolant input port 12 and then flows out of the heat exchanger 1 via the secondary coolant output port 9. The secondary coolant flowing out of the secondary coolant output port 9 may be directed to an external heat exchanger (not shown), where the coolant may be cooled and then returned to the heat exchanger 1 through the first secondary coolant input port 7. This flow of secondary coolant may be described as a secondary coolant loop.

Thus, this mode of operation provides the ability to bring cold facility coolant directly into the chassis 2, to cool one or more cold plates 3, without the need for the coolant to flow via the plates 4, resulting in transfer of heat from the dielectric side of the heat exchanger and thereby heating the coolant unnecessarily.

This is an efficient and effective cooling approach. Improving it to handle a wider variety of applications and implementations remains a challenge.

### Summary of the Disclosure

Against this background, there is provided a heat exchanger as defined by claim 1. A module for cooling electronic components is also provided in accordance with claim 9. Further, a method of configuring a heat exchanger for transfer of heat from a first coolant liquid to a second coolant liquid is provided in accordance with claim 13. Other claims define advantageous and/or more detailed features.

In one aspect, there may be considered a heat exchanger with at least six ports (or a method of configuring such a heat exchanger), a first pair of ports being provided for a primary fluid (typically, but not necessarily, a liquid coolant) and second and third pairs of ports being provided for a secondary fluid (also generally a liquid coolant). The heat exchanger has a thermal interface for transferring heat between the primary and secondary fluids and at least some coolant flows between the second and/or third pair of ports and the thermal interface, for instance in the form of thermal transfer plates. In addition, the heat exchanger may allow some secondary fluid to pass between the second pair of ports and the third pair of ports without flowing through the thermal interface. The flow of the secondary fluid to and/or from the thermal interface is then restricted without restricting its flow between the second and third pairs of ports. The flow restriction is advantageously selective (in that it can be switched on or off) and/or adjustable (in that the magnitude of restriction can be configured, on a continuous scale or from a discrete set of options).

The flow restriction may be achieved by a component configured to sit within one of the ports for the secondary fluid. The component may include an aperture arrangement for restricting flow of the secondary fluid to and/or from the thermal interface. The aperture arrangement may be formed by one or more hole, slot and/or mesh. In one implementation, the component could have two parts: an inner part with a first aperture arrangement; and an outer part with a second aperture arrangement. Relative alignment of the two aperture arrangements thereby sets the fluid flow through the component. The component could be replaceable, but alternatively may be integrated into the heat exchanger. Optionally, the flow restriction may also filter the secondary fluid, for instance for particles above a certain size.

The heat exchanger may form part of a module in which electronic components are contained and cooling, for instance a blade server or similar. The module typically has a chassis with the electronic components inside. The primary fluid in this case is a liquid, typically a dielectric coolant and the module may be operated to keep the primary fluid in liquid phase. One, some or all of the electronic components may be at least partially immersed in the dielectric coolant for their cooling. The secondary fluid is generally also a liquid, for instance water-based and the module may similarly be operated to keep this in liquid phase as well. The secondary fluid may be supplied to one or more cold plates, each cold plate being configured to cool one or more of the electronic components (for instance, by being mounted thereupon). The secondary fluid may pass through the heat exchanger to the cold plate (or cold plates) and also pass through the thermal interface in the heat exchanger to allow transfer of heat between the primary and secondary fluids.

Providing the heat exchanger within the chassis is advantageous, for cooling efficiency and portability of the module. Beneficially, a pump for the primary fluid is also provided within the chassis. The form of the heat exchanger may allow coupling to the second pair of ports external the chassis, with the first and third pairs of ports being coupled to from within the chassis.

In use, the restriction may be configured to set a flow rate of the secondary fluid based on a pressure drop of the secondary fluid flowing between the second and third pairs of ports (that is, bypassing the thermal interface and preferably flowing to one or more cold plates). For example, if the pressure drop increases, the flow rate may be increased accordingly to compensate. Additionally or alternatively, a ratio between a flow rate of the secondary fluid to the thermal interface and a flow rate of the secondary fluid between the second and third pairs of ports may be set to (or maintained at) a predetermined value. This may be achieved by set the flow restriction accordingly.

### Brief Description of the Drawings

The disclosure may be put into practice in a number of ways and preferred embodiments will now be described by way of example only and with reference to the accompanying drawings, in which:
Figure 1 shows a top-down view of an exemplary module comprising a six-port heat exchanger;
Figure 2 shows an isometric view of the module of Figure 1;
Figure 3 depicts a cross section of a heat exchanger with a flow restriction according to a first embodiment of the disclosure;
Figure 4 shows an enlarged portion of Figure 3 for clarity;
Figure 5 illustrates an exploded view of the heat exchanger of Figure 3, showing an adaptor according to a first variant;
Figure 6 shows an adaptor for use with the heat exchanger of Figure 3 according to the first variant;
Figure 7 shows an adaptor for use with the heat exchanger of Figure 3 according to a second variant;
Figure 8 shows an adaptor for use with the heat exchanger of Figure 3 according to a third variant;
Figure 9 shows an adaptor for use with the heat exchanger of Figure 3 according to a fourth variant;
Figure 10 shows an adaptor for use with the heat exchanger of Figure 3 according to a fifth variant;
Figure 11 illustrates an exploded view of an adaptor for use with the heat exchanger of Figure 3 according to a sixth variant;
Figure 12 shows the adaptor of Figure 11 in a first configuration;
Figure 13 shows the adaptor of Figure 11 in a second configuration;
Figure 14 shows an adaptor for use with a second embodiment of a heat exchanger in accordance with the disclosure;
Figure 15 depicts an exploded view of a second embodiment of a heat exchanger in accordance with the disclosure with the adaptor of Figure 14.

### Detailed Description of Preferred Embodiments

Implementation of the disclosure are typically used with modules as shown in Figures 1 and 2. A key issue has been identified with the mode of operation in which some secondary coolant passes through the heat exchanger and some is used for thermal transfer with the primary coolant. Specifically, the hydraulic pressure loss at the outlet port of the heat exchanger for the secondary coolant (specifically, as shown in Figures 1 and 2, the second secondary coolant output port 5 to the cold plates 3) may vary. For instance, the bias of the secondary coolant to pass through the plates 4 may be different between implementations. Similarly, although the pressure drop of the plates 4 may be fixed, the pressure drop of the coolant flowing directly to the cold plates 3 can be variable, for instance depending on: how many cold plates 3 are in the system; the type of each cold plate 3 (for example, with different internal fin/pin patterns and/or structures); and/or length and diameter of the supply hoses or pipes from the heat exchanger 1 to the cold plate 3. As a result, each implementation can have different flow rates to the plates 4 and/or to each cold plate 3. The flow rates may be sub-optimal.

To promote a more optimal flow rate to the cold plates 3, an adaptor is proposed for insertion into the first secondary coolant input port 7 of the heat exchanger 1. The purpose of the adaptor is to reduce the amount of coolant able to go through the plates 4, without restricting the amount of coolant flowing directly through the heat exchanger 1, that is from the first secondary coolant input port 7 through to the second secondary coolant output port 5 (to feed the cold plates 3 thereby). The adaptor may be removable and/or replaceable.

In general sense, there may be considered a heat exchanger for transferring heat from a first coolant liquid to a second coolant liquid, whilst keeping the first and second liquid coolants isolated from one another. The heat exchanger comprises: a first set of ports, for receiving the first coolant liquid at the heat exchanger and outputting the first coolant liquid from the heat exchanger; a second set of ports, for receiving the second coolant liquid at the heat exchanger and outputting the second coolant liquid from the heat exchanger; a third set of ports, for receiving the second coolant liquid at the heat exchanger and outputting the second coolant liquid from the heat exchanger, the second and third sets of ports being in communication within the heat exchanger to allow flow of the second coolant liquid therebetween; and a thermal interface, configured to transfer heat between the first coolant liquid received at the first set of ports and the second coolant liquid received at the second and/or third sets of ports. Then, a flow restrictor is advantageously provided, configured (adjustably or selectively) to restrict flow of the second coolant liquid to and/or from the thermal interface without restricting the flow of the second coolant liquid between the second and third sets of ports.

Another aspect may be found in a module for cooling electronic components, comprising: a chassis for containing the electronic components and a first (dielectric) coolant liquid for at least partially immersing the electronic components (optionally, the electronic components and/or first coolant are also provided); one or more cold plates, configured for cooling at least one of the electronic components, each of the one or more cold plates being configured to receive a second coolant liquid; and a heat exchanger as disclosed herein, configured to transfer heat from the first coolant liquid to the second coolant liquid. The electronic components may include one or more of: one or more circuit boards; one or more integrated circuits; one or more other electronic components (for instance, resistors, capacitors, inductors, transformers). The electronic components may form a computer server or other Information Technology (IT) device.

In yet another aspect, there may be considered a method of configuring a heat exchanger as described herein for transfer of heat from a first coolant liquid to a second coolant liquid, whilst keeping the first and second liquid coolants isolated from one another. The method comprises (selectively or adjustably) restricting flow of the second coolant liquid to and/or from a thermal interface that transfers heat from the first coolant liquid received at the first set of ports to the second coolant liquid received at the second and/or third sets of ports, without restricting the flow of the second coolant liquid between the second and third sets of ports.

A number of optional and/or particularly advantageous features are possible. These may be applied to any one or more of the aspects considered herein. For example, according to an embodiment, the flow restrictor comprises a component. This component may be configured to sit within at least one port from the second and/or third sets of ports. Then, the flow restrictor may comprise an aperture arrangement for restricting flow of the second coolant liquid between the at least one port and the thermal interface.

Beneficially, the flow restrictor is replaceable. This may allow reconfiguration of the flow restrictor for different applications.

In preferred implementations, the thermal interface comprises a plate heat exchanging arrangement. Preferably, the heat exchanger is within the chassis (or integrated with the chassis). Beneficially, there is further provided a pump for the first coolant liquid within the chassis. This may allow effective flow of dielectric coolant around a corresponding coolant loop.

In embodiments, the first and second sets of ports of the heat exchanger are configured to receive coolant from and provide coolant to within the chassis (the first set of ports are typically configured for the flow of a primary coolant, for instance a dielectric liquid and/or the second set of ports are generally configured for flow of secondary coolant to and from one or more cold plates). Then, the third set of ports may be configured to receive coolant from and provide coolant to a device external the chassis, for example a secondary heat exchanger (which may include a heat rejection unit).

Advantageously, restricting flow of the second coolant liquid (optionally, selectively or adjustably) may comprise setting a flow rate of the second coolant liquid based on a pressure drop of the second coolant liquid flowing between the second and third sets of ports and then out of the heat exchanger. Additionally or alternatively, restricting flow of the second coolant liquid may comprise setting to a predetermined value, a ratio between a flow rate of the second coolant liquid to the thermal interface and a flow rate of the second coolant liquid between the second and third sets of ports.

Further optional and/or advantageous features according to the general sense will be discussed below. Before this, additional details of specific embodiments are again described.

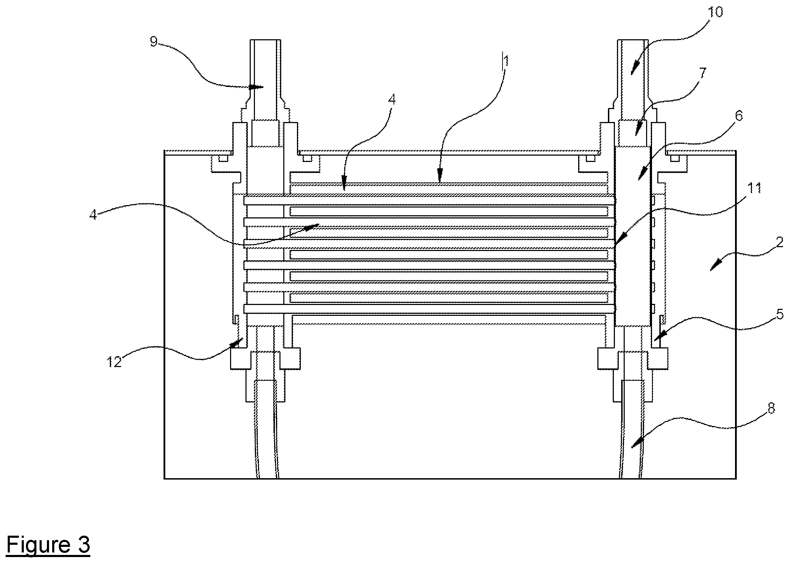

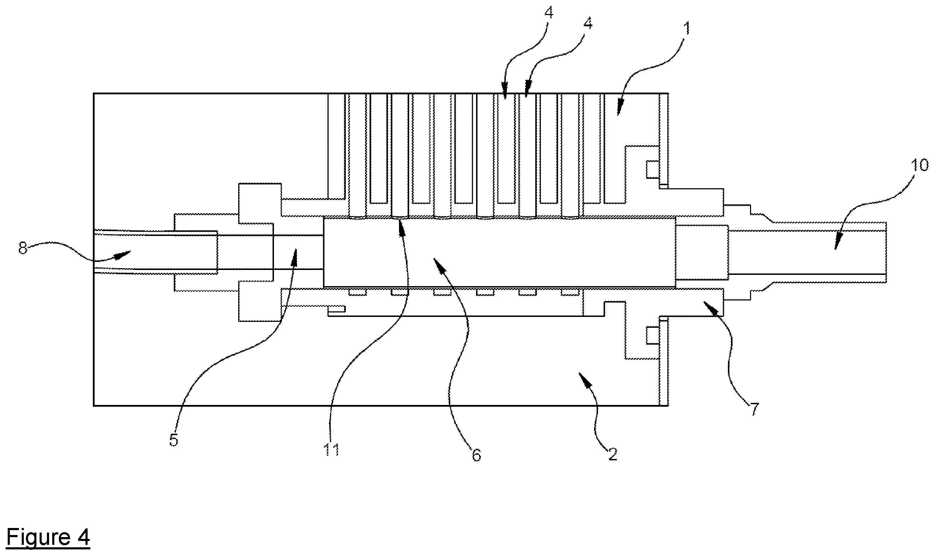

Referring now to Figure 3, there is depicted a cross section of a heat exchanger 1 with a flow restriction, provided by an adaptor 6. Reference is also made to Figure 4, in which there is shown an enlarged portion of Figure 3 for clarity. Where the same features are depicted as shown in other drawings, identical reference numerals have been used. From this drawing, it can be seen that the heat exchanger comprises: heat exchanger plates 4; the first secondary coolant input port 7 with an external connector 10; the first secondary coolant output port 9; the second secondary coolant output port 5; and the second secondary coolant input port 12. Also visible are: the chassis 2; and the pipework 8. The adaptor 6 includes restrictive holes 11.

In the example of Figures 3 and 4, the adaptor 6 has a generally hollow, elongate tubular (or cylindrical) shape and sits inside the facility coolant inlet side of the heat exchanger 1 between the external connector 10 of the first secondary coolant input port 7 and the second secondary coolant output port 5, bypassing the plates 4. Restrictive holes 11 promote flow directly through to the outlet port 5 and pipework 8, making it less attractive for the coolant to go through the plates 4. As will be discussed further below, the holes 11 could include one or more of holes, slots and/or other shapes, based on an optimal shape to result in one or more targeted (predetermined) flow rates. The left-hand side of the heat exchanger 1 shows the second secondary coolant input (return coolant flow) port 12, which in this example, need not be restricted, as there is no benefit for this coolant to bypass the plates 4.

The adaptor 6 could be made from a range of different materials, for example metal and/or plastic. Depending on the implementation, the adaptor 6 could be bespoke to the flow rate restriction needed for a specific use case within the module (and then selectively disabled, by switching out or removal of the adaptor 6, if this were to change) or adjustable so that the flow restriction could be changed without needing to take apart the heat exchanger 1.

Different versions of the adaptor 6 could be used for different arrangements of and/or or different types of cold plates 3. For example, the adaptor 6 may have different predetermined holes and/or slots suitable for different required flow rates. A number of implementations will be discussed below to show a range of possible examples. It will be appreciated that combinations of features from these exemplary designs are also possible.

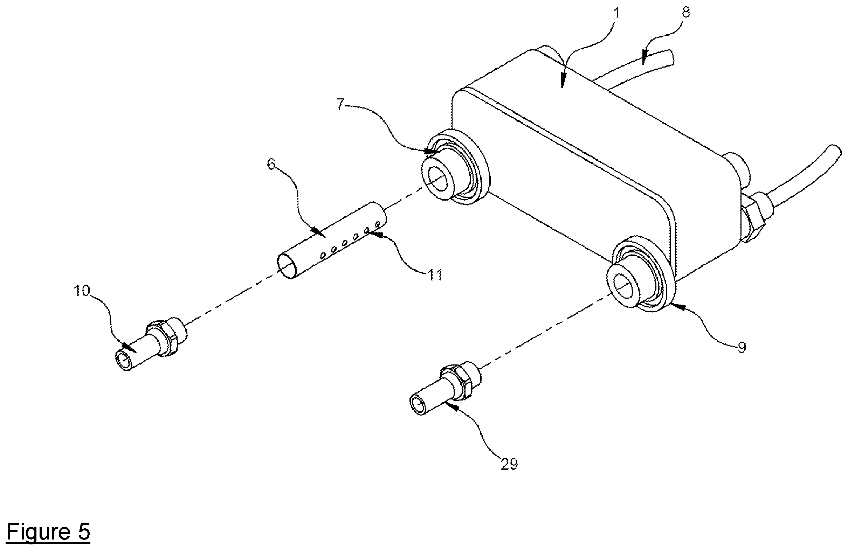

Referring next to Figure 5, there is illustrated an exploded view of the heat exchanger of Figure 3, showing an adaptor according to a first variant. As before, the same features as depicted in other drawings are identified using identical reference numerals. Visible in this drawing are: heat exchanger 1; pipework 8; the first secondary coolant input port 7; adaptor 6 with holes 11; first external connector 10; the first secondary coolant output port 9; and second external connector 29. It can thereby be seen how the adaptor 6 fits into the first secondary coolant input port 7, internal of the first external connector 10.

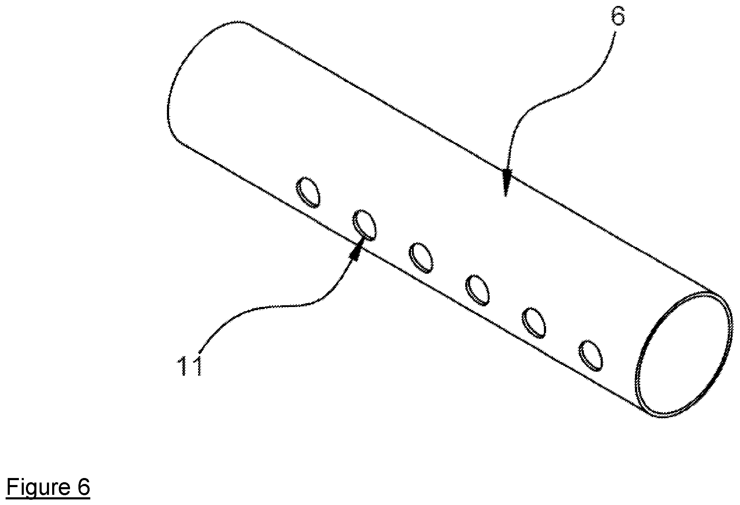

Reference is also made to Figure 6, in which there is shown the adaptor 6 according to the first variant. Restrictive holes 11 can more clearly be seen here.

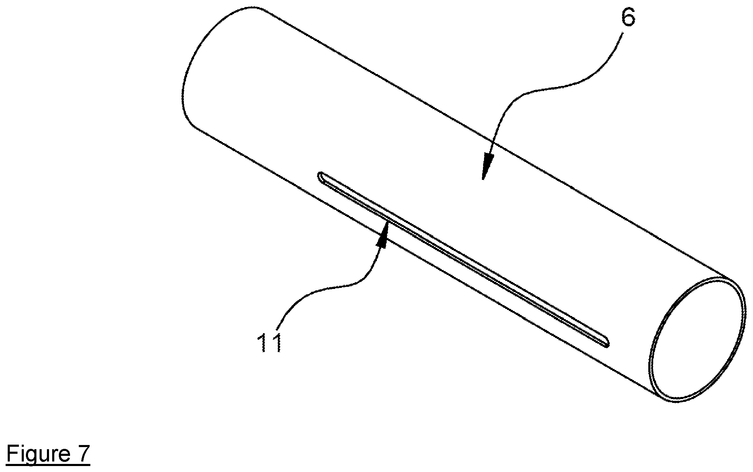

Referring now to Figure 7, there is shown an adaptor 6' for use with the heat exchanger of Figure 3 according to a second variant. Instead of holes, a slot 11' is provided.

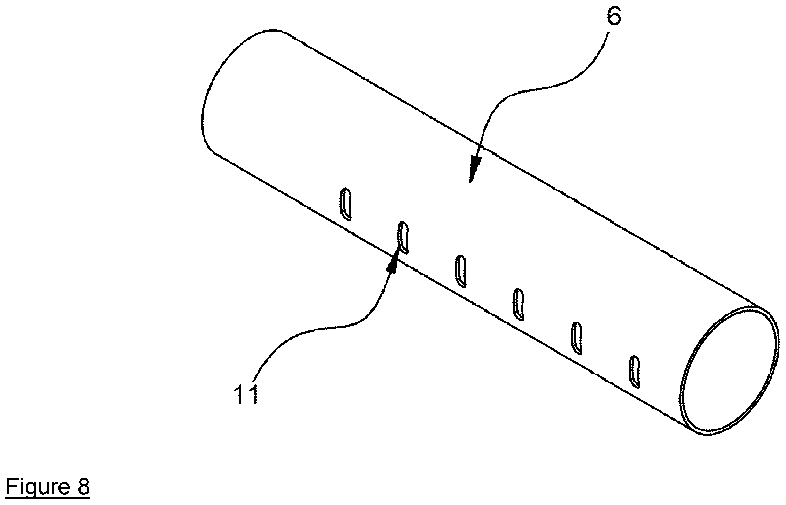

Reference is now made to Figure 8, in which there is shown an adaptor 6" for use with the heat exchanger of Figure 3 according to a third variant. Here, slot-like holes 11" are provided.

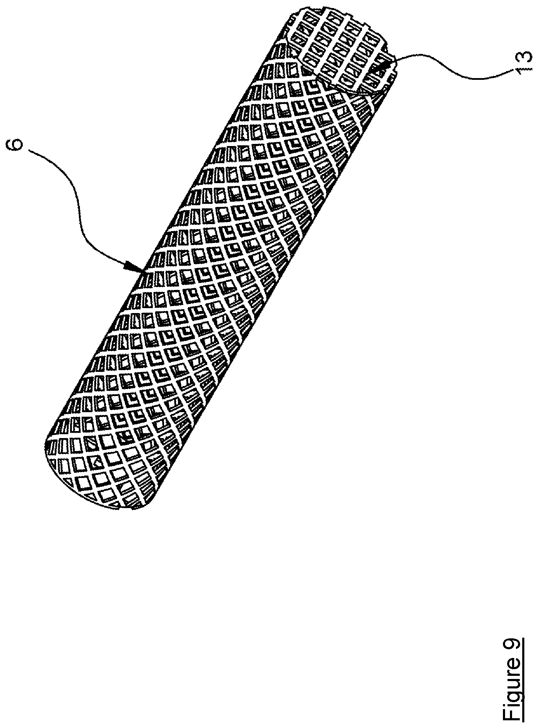

A different type of adaptor may use an alternative structure. For example, reference is made to Figure 9, in which there is shown an adaptor for use with the heat exchanger of Figure 3 according to a fourth variant. The adaptor 6‴ comprises a mesh filter 13. This mesh filter 13 can act to remove harmful particles being drawn into the heat exchanger 1, which might stop the system from working. The gauge of this mesh 13 could be from (for example) 50 microns to 300 microns, depending on the specification and/or materials used in the secondary coolant loop.

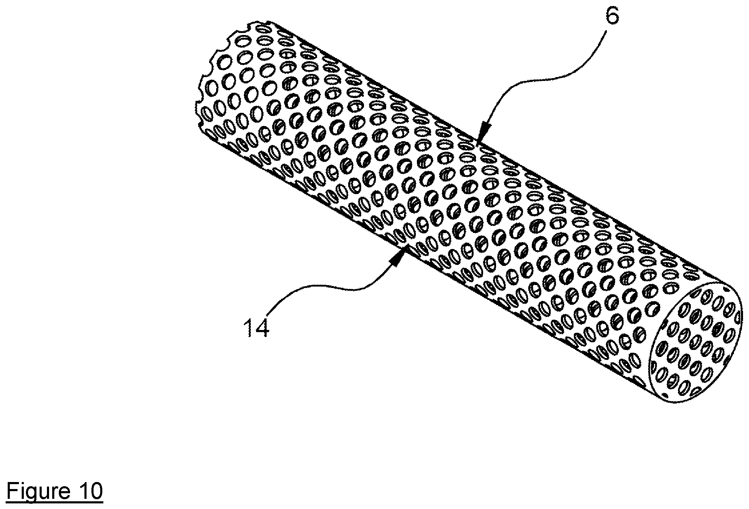

Rather than a mesh, a strainer pattern could also provide filtration, for instance. Referring next to Figure 10, there is shown an adaptor for use with the heat exchanger of Figure 3 according to a fifth variant. The adaptor 6ʺʺ comprises a strainer 14. The strainer 14 can act as a filter, in the same way as mesh 13 and all details of those options would also apply to this implementation.

In these embodiments, the flow restriction can be implemented selectively. In particular, the adaptor 6 can be inserted into or removed from the heat exchanger depending on the desired flow rates.

As mentioned above, an adjustable version of the adaptor (where the magnitude of the restriction can be changed) may be beneficial. For example, this could be used if the items within the module for cooling were likely to change, meaning the amount of flow bypassing the plates 4 of the heat exchanger 1 could be changed without needing to decommission the heat exchanger 1 fully.

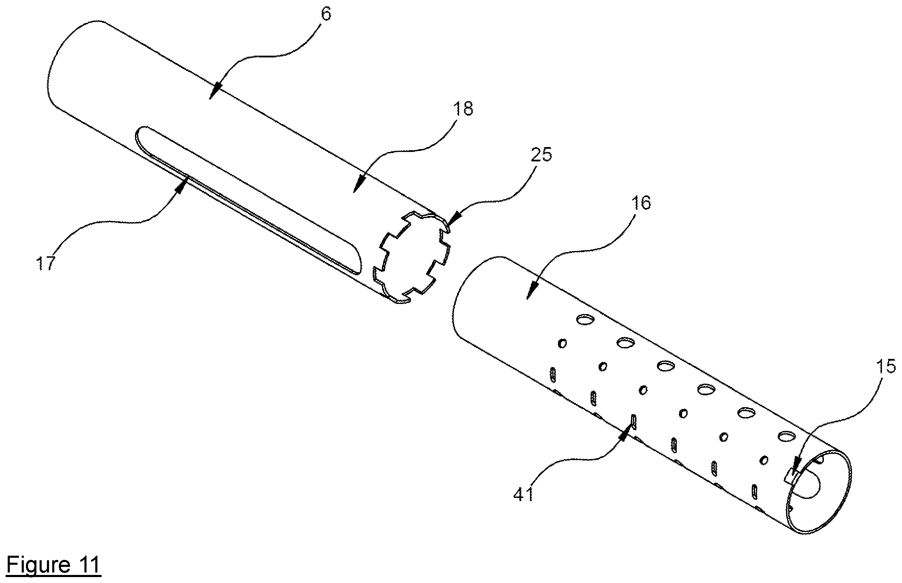

Referring now to Figure 11, there is illustrated an exploded view of an adaptor for use with the heat exchanger of Figure 3 according to a sixth variant. The adaptor 26 comprises: an outer part 18 with an outer slot 17; and an inner part 16 with inner apertures 41. Both the outer part 18 and the inner part 16 have a hollow cylindrical shape with the outer part 18 having a slightly wider size (diameter in this case, because the parts have a circular cross section, but this shape is not essential) than the inner part 16, such that the inner part 16 can fit within the outer part 18. The inner apertures 41 are formed in rows, each row extending along the length of the inner part 16, with different rows at different places along the outer surface of the inner part 16 (circumference). Each row has apertures 41 of a different shape and/or size. In the example shown, the number of apertures 41 in each row is the same, but this is not essential and the number could vary in some implementations (for example, a slot, similar to outer slot 17, could be used in addition to or as an alternative to hole-shaped apertures, such that one or more rows might only have a single aperture).

By alignment of the inner apertures 41 with the outer slot 17, the flow restriction can be adjusted. The inner part 16 is additionally provided with a projection 15 to correspond with notches 25 on the outer part 18. This is an example of a system that could be used to allow the inner part 16 of the adaptor 26 to be twisted and locked into a desired position with respect to the outer part 18.

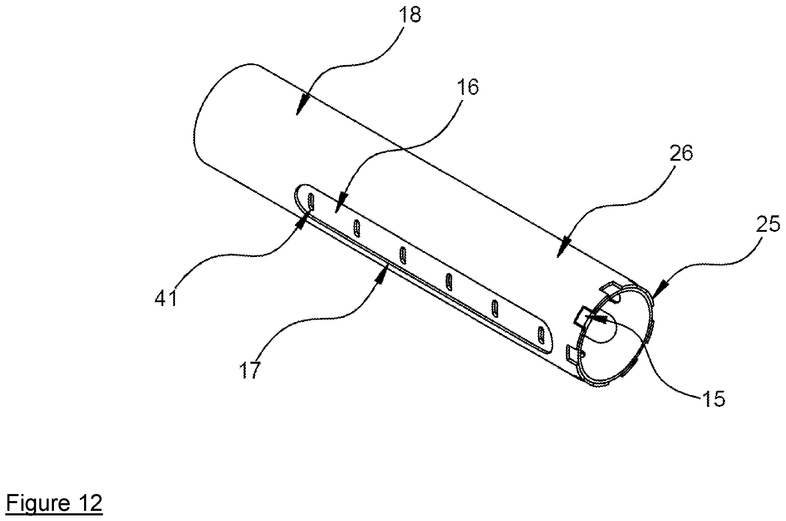

Referring next to Figure 12, there is shown the adaptor of Figure 11 in a first configuration. As can be seen, the inner part 16 fits within the outer part. The fit is fairly tight, so that fluid does not readily bypass the inner apertures 41 to flow through the outer slot 17. In the shown configuration, the inner apertures 41 aligned with the outer slot 17 restrict the flow of fluid through the outer slot 17 by a significant amount. The position of projection 15 within one of the slots 25 locks the positioning of the inner apertures 41. A desired amount of flow restriction to the plates 4 of the heat exchanger 1 is thereby implemented.

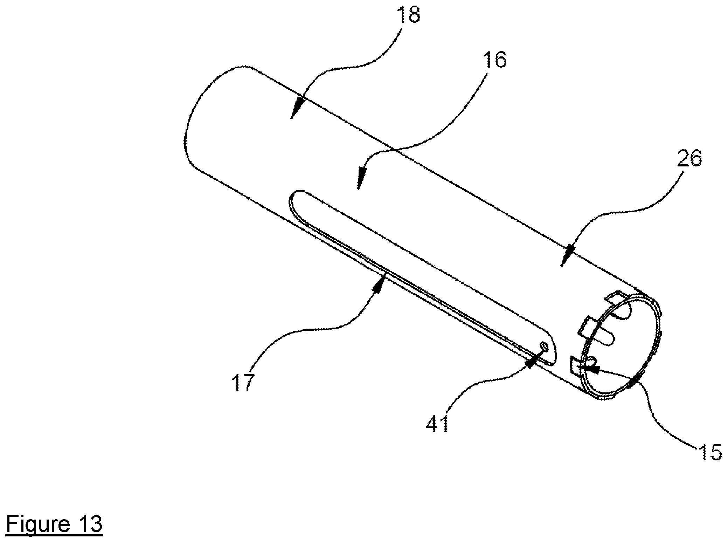

Reference is now made to Figure 13, in which there is shown the adaptor of Figure 11 in a second configuration. Here, the inner aperture 41 that is aligned with the outer slot 17 is only a small hole. As a result, the flow restriction of this configuration is even greater than the flow restriction of the configuration of Figure 12. Conversely, the flow rate through from the first secondary coolant input port 7 to the second secondary coolant output port 5 in this configuration is greater than the corresponding flow rate of the configuration of Figure 12.

Returning to the general sense of the disclosure, as discussed above, additional optional and/or beneficial features can be discussed. For example, the aperture arrangement of the flow restrictor component is beneficially formed by one or more of: one or more holes (which may be arranged in the form of a strainer in certain configurations); one or more slots; and mesh.

In one implementation, the flow restrictor comprises an inner component having a first aperture arrangement and an outer component having a second aperture arrangement. Then, relative alignment of the first and second aperture arrangements may thereby set the flow (amount and/or rate) of the second coolant liquid between the at least one port of the component and the thermal interface.

Optionally, the flow restrictor is further configured to filter the second coolant liquid. For instance, the filtering may be for particles above a certain size. This is an additional possible benefit of the flow restriction according to the disclosure.

Other specific embodiments will again now be discussed. Then, further reference to the general sense of the disclosure will be presented.

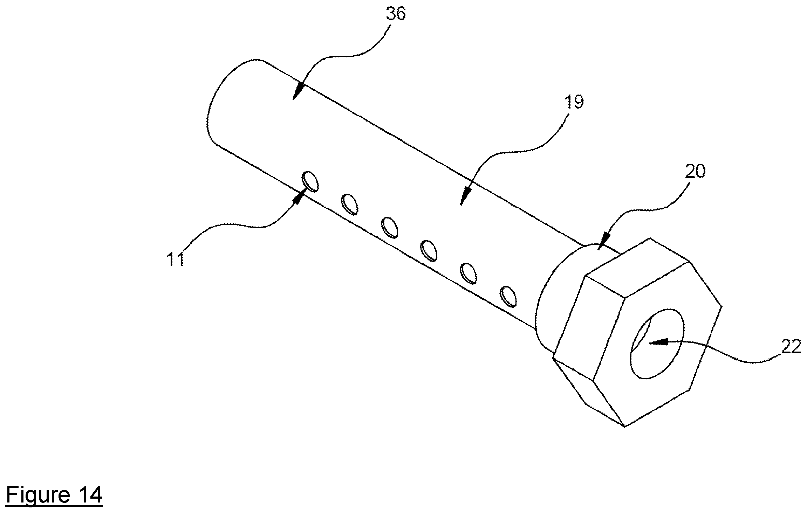

The adaptor designs described thus far are all intended to fit within the first secondary coolant input port 7. However, it will be seen that this is not essential. For example, the adaptor could fit within the second secondary coolant output port 5. Referring next to Figure 14, there is shown an adaptor for use with a heat exchanger according to this approach. The adaptor 36 comprises a tubular portion 19 with apertures 11 and a threaded portion 20 at one end of the tubular portion 19. The threaded portion 20 is designed to couple with the second secondary coolant output port 5, to fix the adaptor 36 in place thereby, and includes a hole 22 to allow flow of coolant via the second secondary coolant output port 5.

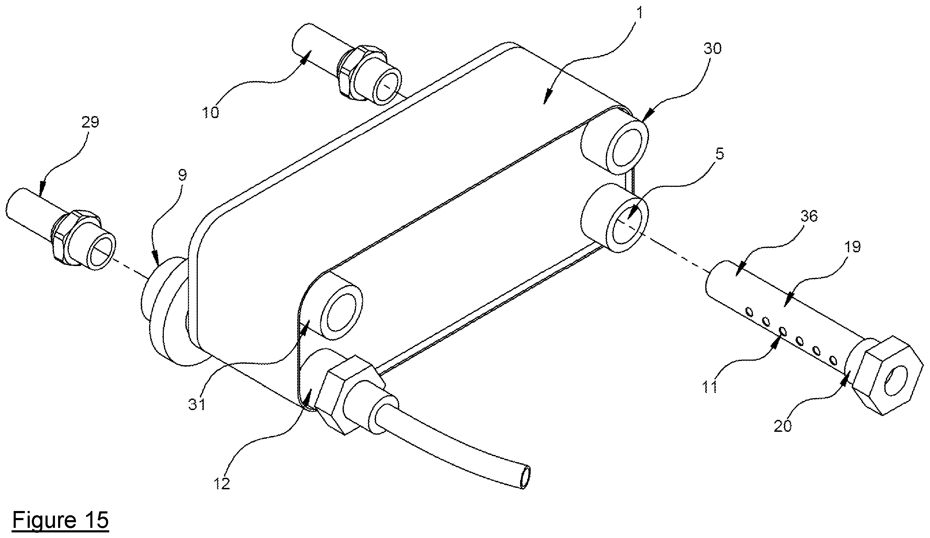

Referring finally to Figure 15, there is depicted an exploded view a heat exchanger in accordance with the adaptor of Figure 14. It can thus be seen how the adaptor 36 fits into the second secondary coolant output port 5 as opposed to the inlet port (the first secondary coolant input port 7).

With reference to the general sense of the disclosure, other optional and/or beneficial features can be provided. For instance, although the flow restrictor may be provided in one of the second set of ports (preferably configured for flow of coolant into the heat exchanger), flow restrictor may be provided in one of the third set of ports (for instance, configured for flow of coolant out of the heat exchanger). In some embodiments, the flow restrictor may be provided in more than one port, for example in one of the second set of ports and in one of the third set of ports (or even in more than two ports). In certain implementations, the flow restrictor may be integrated with the at least one port.

Although specific embodiments have now been described, the skilled person will appreciate that various modifications and alternations are possible. The arrangement of components, heat sinks, pumps, support structures and other configurations may be varied, combined or otherwise configured in a range of different ways, of which those disclosed herein are simply examples. The configuration of the electronic device cooled by one or more heat sinks, one or more plates and/or other electronic devices may vary significantly. The exact shape and/or size of the heat sink and/or cold plate may also be modified. The structure of the heat sink and/or cold plate may also change, for example using other multi-part assemblies or as an integrally constructed device.

Although the disclosure is described with reference to a server module of a specific shape and size, this can be varied (for example, a blade server with a vertical orientation may be used) and indeed, aspects of the disclosure may be applied for cooling other types of device. For example (and as discussed in at least WO-2020/178579, commonly assigned with the present disclosure), cooling technology according to the disclosure can be used to cool a wide variety of different heat-generating (generally electrical and/or electronic) components, including but not limited to IT devices.

The primary and/or secondary coolant are typically liquids and may be maintained in liquid form (single phase coolant). However, this need not necessarily be the case. A two-phase coolant (which may be allowed to change to and from gas phase) and/or refrigerant coolant may be used, particularly for the secondary coolant.

The shape and/or design of the adaptor may be different to that described above. For example, the adaptor need not be tubular or cylindrical in shape.

In the designs described herein, the adaptor is fitted within the first secondary coolant input port 7 or within the second secondary coolant output port 5. However, an adaptor could be fitted into both ports or another port, depending on the application and implementation.

In some embodiments, the flow restriction could be integrated into the manufacture of the heat exchanger 1. This approach could provide a permanent solution that is not modified after the manufacture process, although the flow restriction could be selectively or adjustably controlled in implementations.

All of the features disclosed herein may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

## Claims

1. A heat exchanger for transferring heat from a first coolant liquid to a second coolant liquid, whilst keeping the first and second liquid coolants isolated from one another, the heat exchanger comprising:
a first set of ports, for receiving the first coolant liquid at the heat exchanger and outputting the first coolant liquid from the heat exchanger;
a second set of ports, for receiving the second coolant liquid at the heat exchanger and outputting the second coolant liquid from the heat exchanger;
a third set of ports, for receiving the second coolant liquid at the heat exchanger and outputting the second coolant liquid from the heat exchanger, the second and third sets of ports being in communication within the heat exchanger to allow flow of the second coolant liquid therebetween;
a thermal interface, configured to transfer heat between the first coolant liquid received at the first set of ports and the second coolant liquid received at the second and/or third sets of ports; **characterised by**
a flow restrictor, configured adjustably or selectively to restrict flow of the second coolant liquid to and/or from the thermal interface without restricting the flow of the second coolant liquid between the second and third sets of ports.

2. The heat exchanger of claim 1, wherein the flow restrictor comprises a component configured to sit within at least one port from the second and/or third sets of ports, the flow restrictor comprising an aperture arrangement for restricting flow of the second coolant liquid between the at least one port and the thermal interface.

3. The heat exchanger of claim 2, wherein the aperture arrangement is formed by one or more of: one or more holes; one or more slots; and mesh.

4. The heat exchanger of claim 2 or claim 3, wherein the flow restrictor comprises an inner component having a first aperture arrangement and an outer component having a second aperture arrangement, relative alignment of the first and second aperture arrangements thereby setting the flow of the second coolant liquid between the at least one port and the thermal interface.

5. The heat exchanger of any one of claims 2 to 4, wherein the flow restrictor is replaceable.

6. The heat exchanger of any one of claims 2 to 4, wherein the flow restrictor is integrated with the at least one port.

7. The heat exchanger of any preceding claim, wherein the flow restrictor is further configured to filter the second coolant liquid.

8. The heat exchanger of any preceding claim, wherein the thermal interface comprises a plate heat exchanging arrangement.

9. A module for cooling electronic components, comprising:
a chassis for containing the electronic components and a first coolant liquid for at least partially immersing the electronic components;
one or more cold plates for cooling at least one of the electronic components, each of the one or more cold plates being configured to receive a second coolant liquid; and
a heat exchanger according to any preceding claim, configured to transfer heat from the first coolant liquid to the second coolant liquid.

10. The module of claim 9, wherein the heat exchanger is within the chassis.

11. The module of claim 9 or claim 10, further comprising:
a pump for the first coolant liquid within the chassis.

12. The module of any one of claims 9 to 11, wherein the first and second sets of ports of the heat exchanger are configured to receive coolant from and provide coolant to within the chassis and the third set of ports is configured to receive coolant from and provide coolant to a device external the chassis.

13. A method of configuring a heat exchanger for transfer of heat from a first coolant liquid to a second coolant liquid, whilst keeping the first and second liquid coolants isolated from one another, the heat exchanger comprising: a first set of ports, for receiving the first coolant liquid at the heat exchanger and outputting the first coolant liquid from the heat exchanger; a second set of ports, for receiving the second coolant liquid at the heat exchanger and outputting the second coolant liquid from the heat exchanger; and a third set of ports, for receiving the second coolant liquid at the heat exchanger and outputting the second coolant liquid from the heat exchanger, the second and third sets of ports being in communication within the heat exchanger to allow flow of the second coolant liquid therebetween, the method comprising:
restricting flow of the second coolant liquid to and/or from a thermal interface of the heat exchanger that transfers heat from the first coolant liquid received at the first set of ports to the second coolant liquid received at the second and/or third sets of ports, without restricting the flow of the second coolant liquid between the second and third sets of ports.

14. The method of claim 13, wherein the step of restricting flow of the second coolant liquid comprises setting a flow rate of the second coolant liquid based on a pressure drop of the second coolant liquid flowing between the second and third sets of ports and then out of the heat exchanger.

15. The method of claim 13 or claim 14, wherein the step of restricting flow of the second coolant liquid comprises setting to a predetermined value, a ratio between a flow rate of the second coolant liquid to the thermal interface and a flow rate of the second coolant liquid between the second and third sets of ports.

## Patentansprüche

1. Wärmetauscher zum Übertragen von Wärme von einem ersten flüssigen Kühlmittel auf ein zweites flüssiges Kühlmittel, wobei das erste und das zweite flüssige Kühlmittel voneinander getrennt bleiben, wobei der Wärmetauscher umfasst:
einen ersten Satz von Anschlüssen zum Aufnehmen des ersten flüssigen Kühlmittels am Wärmetauscher und zum Ausgeben des ersten flüssigen Kühlmittels aus dem Wärmetauscher;
einen zweiten Satz von Anschlüssen zum Aufnehmen des zweiten flüssigen Kühlmittels am Wärmetauscher und zum Ausgeben des zweiten flüssigen Kühlmittels aus dem Wärmetauscher;
einen dritten Satz von Anschlüssen zum Empfangen des zweiten flüssigen Kühlmittels am Wärmetauscher und zum Ausgeben des zweiten flüssigen Kühlmittels aus dem Wärmetauscher, wobei der zweite und der dritte Satz von Anschlüssen innerhalb des Wärmetauschers miteinander in Verbindung stehen, um einen Durchfluss des zweiten flüssigen Kühlmittels zwischen ihnen zu ermöglichen;
eine thermische Schnittstelle, die dazu konfiguriert ist, Wärme zwischen dem ersten flüssigen Kühlmittel, das an dem ersten Satz von Anschlüssen aufgenommen wird, und dem zweiten flüssigen Kühlmittel, das an dem zweiten und/oder dritten Satz von Anschlüssen aufgenommen wird, zu übertragen; **gekennzeichnet durch**
eine Durchflussbegrenzungseinrichtung, die so konfiguriert ist, dass sie einen Durchfluss des zweiten flüssigen Kühlmittels zu und/oder von der thermischen Schnittstelle einstellbar oder wahlweise begrenzt, ohne den Durchfluss des zweiten flüssigen Kühlmittels zwischen dem zweiten und dem dritten Satz von Anschlüssen zu begrenzen.

2. Wärmetauscher nach Anspruch 1, wobei die Durchflussbegrenzungseinrichtung ein Bauteil umfasst, das so konfiguriert ist, dass es in mindestens einem Anschluss aus dem zweiten und/oder dritten Satz von Anschlüssen sitzt, wobei die Durchflussbegrenzungseinrichtung eine Öffnungsanordnung zum Begrenzen eines Durchflusses des zweiten flüssigen Kühlmittels zwischen dem mindestens einen Anschluss und der thermischen Schnittstelle umfasst.

3. Wärmetauscher nach Anspruch 2, wobei die Öffnungsanordnung durch eines oder mehrere von Folgendem ausgebildet ist: einem oder mehreren Löcher; einem oder mehreren Schlitze; und Maschen.

4. Wärmetauscher nach Anspruch 2 oder Anspruch 3, wobei die Durchflussbegrenzungseinrichtung ein inneres Bauteil mit einer ersten Öffnungsanordnung und ein äußeres Bauteil mit einer zweiten Öffnungsanordnung umfasst, wobei eine relative Ausrichtung der ersten und der zweiten Öffnungsanordnung dadurch den Durchfluss des zweiten flüssigen Kühlmittels zwischen dem mindestens einen Anschluss und der thermischen Schnittstelle bestimmt.

5. Wärmetauscher nach einem der Ansprüche 2 bis 4, wobei die Durchflussbegrenzungseinrichtung austauschbar ist.

6. Wärmetauscher nach einem der Ansprüche 2 bis 4, wobei die Durchflussbegrenzungseinrichtung mit dem mindestens einen Anschluss integriert ist.

7. Wärmetauscher nach einem vorstehenden Anspruch, wobei die Durchflussbegrenzungseinrichtung weiter dazu konfiguriert ist, das zweite flüssige Kühlmittel zu filtern.

8. Wärmetauscher nach einem vorstehenden Anspruch, wobei die thermische Schnittstelle eine Plattenwärmetauschanordnung umfasst.

9. Modul zum Kühlen elektronischer Bauteile, umfassend:
ein Gehäuse zum Aufnehmen der elektronischen Bauteile und eines ersten flüssigen Kühlmittels zum zumindest teilweisen Eintauchen der elektronischen Bauteile;
eine oder mehrere Kühlplatten zum Kühlen mindestens einer der elektronischen Bauteile, wobei jede der einen oder mehreren Kühlplatten so konfiguriert ist, dass sie ein zweites flüssiges Kühlmittel aufnimmt; und
einen Wärmetauscher nach einem der vorstehenden Ansprüche, so konfiguriert, dass Wärme von dem ersten flüssigen Kühlmittel auf das zweite flüssige Kühlmittel übertragen wird.

10. Modul nach Anspruch 9, wobei sich der Wärmetauscher innerhalb des Gehäuses befindet.

11. Modul nach Anspruch 9 oder Anspruch 10, weiter umfassend:
eine Pumpe für das erste flüssige Kühlmittel innerhalb des Gehäuses.

12. Modul nach einem der Ansprüche 9 bis 11, wobei der erste und der zweite Satz von Anschlüssen des Wärmetauschers so konfiguriert sind, dass sie Kühlmittel aus dem Gehäuse aufnehmen und an ein Inneres des Gehäuses bereitstellen, und der dritte Satz von Anschlüssen so konfiguriert ist, dass sie Kühlmittel von einer außerhalb des Gehäuses befindlichen Vorrichtung aufnehmen und dieser bereitstellt.

13. Verfahren zum Konfigurieren eines Wärmetauschers zum Übertragen von Wärme von einem ersten flüssigen Kühlmittel auf ein zweites flüssiges Kühlmittel, wobei das erste und das zweite flüssige Kühlmittel voneinander getrennt bleiben, wobei der Wärmetauscher umfasst: einen ersten Satz von Anschlüssen zum Aufnehmen des ersten flüssigen Kühlmittels am Wärmetauscher und zum Ausgeben des ersten flüssigen Kühlmittels aus dem Wärmetauscher; einen zweiten Satz von Anschlüssen zum Aufnehmen des zweiten flüssigen Kühlmittels am Wärmetauscher und zum Ausgeben des zweiten flüssigen Kühlmittels aus dem Wärmetauscher; und einen dritten Satz von Anschlüssen zum Aufnehmen des zweiten flüssigen Kühlmittels am Wärmetauscher und zum Ausgeben des zweiten flüssigen Kühlmittels aus dem Wärmetauscher, wobei der zweite und der dritte Satz von Anschlüssen innerhalb des Wärmetauschers miteinander in Verbindung stehen, um einen Durchfluss des zweiten flüssigen Kühlmittels zwischen ihnen zu ermöglichen, wobei das Verfahren umfasst:
Begrenzen eines Durchflusses des zweiten flüssigen Kühlmittels zu und/oder von einer thermischen Schnittstelle des Wärmetauschers, die Wärme von dem an dem ersten Satz von Anschlüssen aufgenommenen ersten flüssigen Kühlmittel auf das an dem zweiten und/oder dritten Satz von Anschlüssen aufgenommene zweite flüssige Kühlmittel überträgt, ohne den Durchfluss des zweiten flüssigen Kühlmittels zwischen dem zweiten und dem dritten Satz von Anschlüssen zu begrenzen.

14. Verfahren nach Anspruch 13, wobei der Schritt des Begrenzens eines Durchflusses des zweiten flüssigen Kühlmittels ein Einstellen einer Durchflussrate des zweiten flüssigen Kühlmittels auf der Grundlage eines Druckabfalls des zweiten flüssigen Kühlmittels umfasst, das zwischen dem zweiten und dem dritten Satz von Anschlüssen und anschließend aus dem Wärmetauscher strömt.

15. Verfahren nach Anspruch 13 oder Anspruch 14, wobei der Schritt des Begrenzens eines Durchflusses des zweiten flüssigen Kühlmittels ein Einstellen eines Verhältnisses zwischen einer Durchflussrate des zweiten flüssigen Kühlmittels zur thermischen Schnittstelle und einer Durchflussrate des zweiten flüssigen Kühlmittels zwischen dem zweiten und dem dritten Satz von Anschlüssen auf einen vorgegebenen Wert umfasst.

## Revendications

1. Échangeur de chaleur pour transférer de la chaleur d'un premier liquide de refroidissement à un deuxième liquide de refroidissement, tout en maintenant les premier et deuxième liquides de refroidissement isolés l'un de l'autre, l'échangeur de chaleur comprenant :
un premier ensemble d'orifices, pour recevoir le premier liquide de refroidissement au niveau de l'échangeur de chaleur et évacuer le premier liquide de refroidissement de l'échangeur de chaleur ;
un deuxième ensemble d'orifices, pour recevoir le deuxième liquide de refroidissement au niveau de l'échangeur de chaleur et évacuer le deuxième liquide de refroidissement de l'échangeur de chaleur ;
un troisième ensemble d'orifices, pour recevoir le deuxième liquide de refroidissement au niveau de l'échangeur de chaleur et évacuer le deuxième liquide de refroidissement de l'échangeur de chaleur, les deuxième et troisième ensembles d'orifices étant en communication à l'intérieur de l'échangeur de chaleur pour permettre l'écoulement du deuxième liquide de refroidissement entre eux ;
une interface thermique, configurée pour transférer de la chaleur entre le premier liquide de refroidissement reçu au niveau du premier ensemble d'orifices et le deuxième liquide de refroidissement reçu au niveau des deuxième et/ou troisième ensembles d'orifices ; **caractérisé par**
un limiteur de débit, configuré pour, de manière ajustable ou sélective, limiter le débit du deuxième liquide de refroidissement en direction et/ou en provenance de l'interface thermique sans limiter le débit du deuxième liquide de refroidissement entre les deuxième et troisième ensembles d'orifices.

2. Échangeur de chaleur selon la revendication 1, dans lequel le limiteur de débit comprend un composant configuré pour se loger à l'intérieur d'au moins un orifice parmi les deuxième et/ou troisième ensembles d'orifices, le limiteur de débit comprenant un agencement d'ouvertures pour limiter le débit du deuxième liquide de refroidissement entre ledit au moins un orifice et l'interface thermique.

3. Échangeur de chaleur selon la revendication 2, dans lequel l'agencement d'ouvertures est formé par un ou plusieurs parmi les éléments suivants : un ou plusieurs trous ; une ou plusieurs fentes ; et un grillage.

4. Échangeur de chaleur selon la revendication 2 ou la revendication 3, dans lequel le limiteur de débit comprend un composant interne présentant un premier agencement d'ouvertures et un composant externe présentant un deuxième agencement d'ouvertures, l'alignement relatif des premier et deuxième agencements d'ouvertures réglant ainsi le débit du deuxième liquide de refroidissement entre ledit au moins un orifice et l'interface thermique.

5. Échangeur de chaleur selon l'une quelconque des revendications 2 à 4, dans lequel le limiteur de débit est remplaçable.

6. Échangeur de chaleur selon l'une quelconque des revendications 2 à 4, dans lequel le limiteur de débit est intégré audit au moins un orifice.

7. Échangeur de chaleur selon une quelconque revendication précédente, dans lequel le limiteur de débit est configuré en outre pour filtrer le deuxième liquide de refroidissement.

8. Échangeur de chaleur selon une quelconque revendication précédente, dans lequel l'interface thermique comprend un agencement d'échange de chaleur à plaques.

9. Module pour refroidir des composants électroniques, comprenant :
un châssis pour contenir les composants électroniques et un premier liquide de refroidissement pour immerger au moins partiellement les composants électroniques ;
une ou plusieurs plaques froides pour refroidir au moins un des composants électroniques, chacune des une ou plusieurs plaques froides étant configurée pour recevoir un deuxième liquide de refroidissement ; et
un échangeur de chaleur selon une quelconque revendication précédente, configuré pour transférer de la chaleur du premier liquide de refroidissement au deuxième liquide de refroidissement.

10. Module selon la revendication 9, dans lequel l'échangeur de chaleur est à l'intérieur du châssis.

11. Module selon la revendication 9 ou la revendication 10, comprenant en outre :
une pompe pour le premier liquide de refroidissement à l'intérieur du châssis.

12. Module selon l'une quelconque des revendications 9 à 11, dans lequel les premier et deuxième ensembles d'orifices de l'échangeur de chaleur sont configurés pour recevoir du liquide de refroidissement depuis l'intérieur du châssis et fournir du liquide de refroidissement à l'intérieur du châssis, et le troisième ensemble d'orifices est configuré pour recevoir du liquide de refroidissement depuis un dispositif externe au châssis et fournir du liquide de refroidissement au dispositif externe.

13. Procédé de configuration d'un échangeur de chaleur pour le transfert de chaleur d'un premier liquide de refroidissement à un deuxième liquide de refroidissement, tout en maintenant les premier et deuxième liquides de refroidissement isolés l'un de l'autre, l'échangeur de chaleur comprenant : un premier ensemble d'orifices, pour recevoir le premier liquide de refroidissement au niveau de l'échangeur de chaleur et évacuer le premier liquide de refroidissement de l'échangeur de chaleur ; un deuxième ensemble d'orifices, pour recevoir le deuxième liquide de refroidissement au niveau de l'échangeur de chaleur et évacuer le deuxième liquide de refroidissement de l'échangeur de chaleur ; et un troisième ensemble d'orifices, pour recevoir le deuxième liquide de refroidissement au niveau de l'échangeur de chaleur et évacuer le deuxième liquide de refroidissement de l'échangeur de chaleur, les deuxième et troisième ensembles d'orifices étant en communication à l'intérieur de l'échangeur de chaleur pour permettre l'écoulement du deuxième liquide de refroidissement entre eux, le procédé comprenant :
la limitation du débit du deuxième liquide de refroidissement en direction et/ou en provenance d'une interface thermique de l'échangeur de chaleur qui transfère de la chaleur du premier liquide de refroidissement reçu au niveau du premier ensemble d'orifices au deuxième liquide de refroidissement reçu au niveau des deuxième et/ou troisième ensembles d'orifices, sans limiter le débit du deuxième liquide de refroidissement entre les deuxième et troisième ensembles d'orifices.

14. Procédé selon la revendication 13, dans lequel l'étape de limitation de débit du deuxième liquide de refroidissement comprend le réglage d'un débit du deuxième liquide de refroidissement sur la base d'une perte de charge du deuxième liquide de refroidissement s'écoulant entre les deuxième et troisième ensembles d'orifices, puis hors de l'échangeur de chaleur.

15. Procédé selon la revendication 13 ou la revendication 14, dans lequel l'étape de limitation de débit du deuxième liquide de refroidissement comprend le réglage, à une valeur prédéterminée, d'un rapport entre un débit du deuxième liquide de refroidissement vers l'interface thermique et un débit du deuxième liquide de refroidissement entre les deuxième et troisième ensembles d'orifices.
